# EUROPEAN PATENT SPECIFICATION

(11) **EP 4 577 790 B1**
(45) Date of publication and mention of the grant of the patent: **24.06.2026**
(21) Application number: 22789581.0
(22) Date of filing: 23.09.2022
(51) Int. Cl.: F28D 15/04

(54) **TWO-PHASE HEAT SINK FOR COOLING HEAT SOURCES**
ZWEIPHASIGER KÜHLKÖRPER ZUR KÜHLUNG VON WÄRMEQUELLEN
DISSIPATEUR THERMIQUE À DEUX PHASES POUR LE REFROIDISSEMENT DE SOURCES DE CHALEUR

(43) Date of publication of application: 02.07.2025
(73) Proprietor: Huawei Technologies Co., Ltd., Shenzhen, Guangdong 518129 (CN)
(72) Inventor: TSOI, Vadim, 16440 Kista (SE); OHLSSON, Fredrik, 16440 Kista (SE); KUSHNER, Dzmitry, 16440 Kista (SE); DONG, Ying, 16440 Kista (SE); MAKHNATCH, Pavel, 16440 Kista (SE); DIVANDARI, Mohammad, 16440 Kista (SE); JARPNER, Christoffer, 16440 Kista (SE); NIU, Junchao, 16440 Kista (SE)
(74) Representative: Isarpatent
(86) International application number: PCT/EP2022/076532
(87) International publication number: WO 2024/061470

(56) References cited:
- EP-B1- 3 988 885
- US-A1- 2006 237 167
- US-A1- 2008 170 368
- US-A1- 2022 299 271

## Description

### TECHNICAL FIELD

Embodiments of the invention relate to a two-phase heat sink for cooling electrical heat sources and to a heat sink comprising two or more such two-phase heat sinks. More specifically, the invention relates to two-phase heat sinks as defined in the preamble of claim 1, and as illustrated in US2006/237167A.

### BACKGROUND

With the development of communication technologies, outdoor base station devices exhibit higher transmission speeds, larger power output, and higher heat consumption. Especially for remote radio units (RRUs) and multiple input multiple output (MIMO) devices in the 3GPP 5G network, the base station device system is highly integrated and strongly depends on the natural cooling capability of cooling devices.

Due to the requirements for flexible base station deployment and long-term reliability in complex environments, cooling fans or circulating liquid cooling are seldomly used in RRUs and MIMO devices. Therefore, how to further improve the natural heat dissipation capability of the cooling device is critical for future base stations.

### SUMMARY

An objective of embodiments of the invention is to provide a solution which mitigates or solves the drawbacks and problems of existing techniques.

Another objective of embodiments of the invention is to provide a solution providing improved cooling compared to conventional solutions.

The above and further objectives are solved by the subject matter of the independent claims. Further embodiments of the invention can be found in the dependent claims.

According to a first aspect of the invention, the above mentioned and other objectives are achieved with a two-phase heat sink for cooling an electrical heat source, the two-phase heat sink comprising:
a chamber configured to receive a cooling fluid, the chamber comprising a first wall section and a second wall section arranged opposite to the first wall section;
cooling fins coupled to the chamber thereby allowing the cooling fluid to circulate between the chamber and the cooling fins in operation;
an attachment area arranged at an outer surface of the first wall section for attaching a heat source to the first wall section; and
a wick area for converting the cooling fluid from a liquid phase to a vapor phase, the wick area being arranged at an inner surface of the first wall section, wherein the attachment area and the wick area overlap with each other at least partly.

The expression "in operation" may herein mean that the two-phase heat sink is mounted and is ready for use or in actual use. In the latter case operating according to the disclosed technical features.

An advantage of the two-phase heat sink according to the first aspect is that the cooling capacity is improved compared to conventional two-phase heat sinks. This is due to the capillary effect of the wick area improving the phase conversion of the cooling fluid. This also means that the volume of cooling fluid needed in the two-phase heat sink may be reduced implying lower weight and smaller dimension of the two-phase heat sink.

In an implementation form of a two-phase heat sink according to the first aspect, the wick area is a porous wick area.

An advantage with this implementation form is that the cooling capability is further improved due to the porous wick area which means that a higher conversion factor of the cooling fluid from the liquid to vapor phase is possible.

In an implementation form of a two-phase heat sink according to the first aspect, the wick area is larger than the attachment area.

An advantage with this implementation form is that the cooling of the heat source is improved due to the larger wick area.

In an implementation form of a two-phase heat sink according to the first aspect, the wick area and the attachment area are aligned in relation to each other.

An advantage with this implementation form is that the heat generated by the heat source will have a short heat transmission path thereby reducing the thermal resistance and improving the heat dissipation capability.

In an implementation form of a two-phase heat sink according to the first aspect, the wick area and the attachment area are offset in relation to each other.

An advantage with this implementation form is that by offsetting the wick area from the attachment area, the height of the cooling fluid in the two-phase heat sink can be adjusted by capillary forces and the filling amount of the cooling fluid can thus be reduced.

In an implementation form of a two-phase heat sink according to the first aspect, the wick area is offset in relation to the attachment area in a gravity direction of the two-phase heat sink in operation.

An advantage with this implementation form is that the height of the cooling fluid in the two-phase heat sink can be adjusted even further.

In an implementation form of a two-phase heat sink according to the first aspect, the cooling fins are roll-bonded cooling fins.

The roll-bonded cooling fins may have a honeycomb structure.

An advantage with this implementation form is that roll-bonded cooling fins maximizes the condensation area thus improving the cooling capability of the two-phase heat sink. The roll-bonded cooling fins also provide a mechanical robust cooling fin structure.

In an implementation form of a two-phase heat sink according to the first aspect, the roll-bonded cooling fins comprise a first plate section and a second plate section and multiple supporting elements arranged between the first plate section and the second plate section, and wherein a distance between two adjacent supporting elements is in the range between 1.0 - 5.0 mm and preferably in the range between 3.0 - 4.0 mm.

An advantage with this implementation form is that the cooling capability of the two-phase heat sink is further improved.

In an implementation form of a two-phase heat sink according to the first aspect, the supporting elements are integrated with the first plate section and the second plate section.

In an implementation form of a two-phase heat sink according to the first aspect, the chamber is coupled to the roll-bonded cooling fins via one or more input/output ports.

In an implementation form of a two-phase heat sink according to the first aspect, a distance between the wick area and an inside surface of the second wall section is in the range between 1.0 - 10.0 mm, preferably in the range between 1.5 - 7 mm, and more preferably in the range between 1.5 - 5 mm.

An advantage with this implementation form is that the above given gap ranges between the wick area and the inside surface of the second wall section makes the cooling fluid boil more easily. Thus, with this boiling enhancement the weight of the two-phase heat sink can be reduced and at the same time improve the cooling capacity.

In an implementation form of a two-phase heat sink according to the first aspect, the second wall section is formed from a cover plate, and wherein the cooling fins extend through the cover plate perpendicular to the first wall section.

In an implementation form of a two-phase heat sink according to the first aspect, the second wall section is parallel to the first wall section.

According to a second aspect of the invention, the above mentioned and other objectives are achieved with a heat sink for cooling electrical heat sources, the heat sink comprising a first two-phase heat sink according to embodiments of the invention and at least one second two-phase heat sink according to embodiments of the invention.

Thus, it is provided a simplified mechanical design and integration solution for a heat sink comprising two or more two-phase heat sinks. The multi-partitioning design of substrate accommodating chambers and the number and shape of the independent chambers can be adjusted depending on the requirements of the cooling application. Thus, the cooling fluid filling amount can also be flexibly adjusted.

In an implementation form of a heat sink according to the second aspect, the cooling fluid of the first two-phase heat sink is separated from the cooling fluid of the second two-phase heat sink.

An advantage with this implementation form is that the phase conversion of the separate two-phase heat sinks can be performed without interfering with each other. This is due to the fact that the evaporation and condensation cycles in the different two-phase heat sinks are performed independently thereby improving the overall temperature uniformity of the heat sink and therefore improving the cooling capability of the heat sink.

In an implementation form of a heat sink according to the second aspect, the first two-phase heat sink and the second two-phase heat sink have a common substrate plate.

An advantage with this implementation form is that the common substrate makes the design simpler. Further, the common substrate increases the uniformity of the heat sink temperature for improved cooling.

In an implementation form of a heat sink according to the second aspect, the first two-phase heat sink and the second two-phase heat sink are mechanically connected to each other.

An advantage with this implementation form is that the overall strength of the heat sink structure is improved thereby providing a robust heat sink.

Further applications and advantages of embodiments of the invention will be apparent from the following detailed description.

### BRIEF DESCRIPTION OF THE DRAWINGS

The appended drawings are intended to clarify and explain different embodiments of the invention, in which:
- Fig. 1 - 3 show a two-phase heat sink according to embodiments of the invention;
- Fig. 4a and 4b show in detail exemplary wick structures used in the two-phase heat sink according to embodiments of the invention; and
- Fig. 5 - 8 shows design, layout and function of heat sinks according to embodiments of the invention.

### DETAILED DESCRIPTION

Currently, conventional cooling devices for base stations are mainly formed by die-casting aluminum alloy and commonly includes a solid substrate and a plurality of heat dissipating cooling fins on the back of the solid substrate. The solid substrate contacts a printed circuit board and heat from a heat source on the printed circuit board is transferred from the printed circuit board to cooling fins through the solid substrate. The cooling fins dissipate heat to the surrounding air through convection and radiation. The heat dissipation effect in the whole heat transfer path in the conventional solution is affected by the low thermal conductivity of the die-cast aluminum solid substrate, e.g., < 200 W/mK.

Hence, if an equivalent thermal conductivity of substrate and cooling fins can be improved, the cooling capability of the cooling device can be improved. Therefore, it is herein disclosed a two-phase heat sink configured to use a cooling fluid for two-phase cooling in a more efficient way compared to conventional solutions. Thus, the cooling fluid, also known as refrigerant in the art, can have maximized boiling zones and thereby reducing the non-boiling zones. This means that the amount of cooling fluid used can be reduced which also implies that the weight of the two-phase heat sink can be reduced.

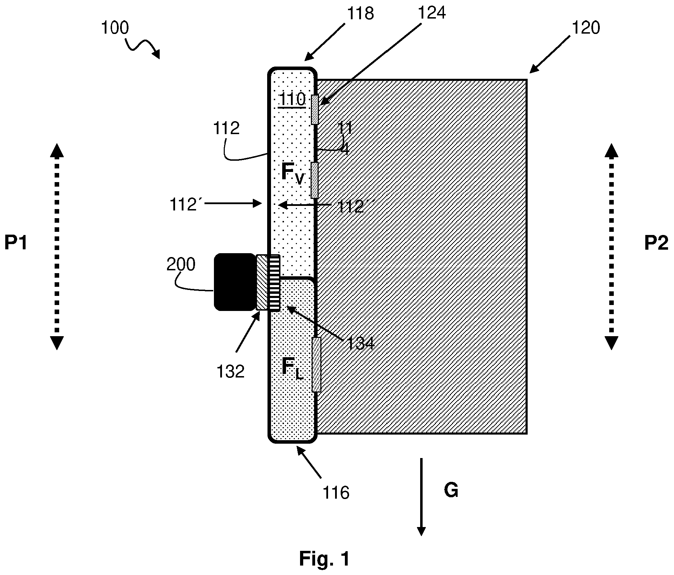

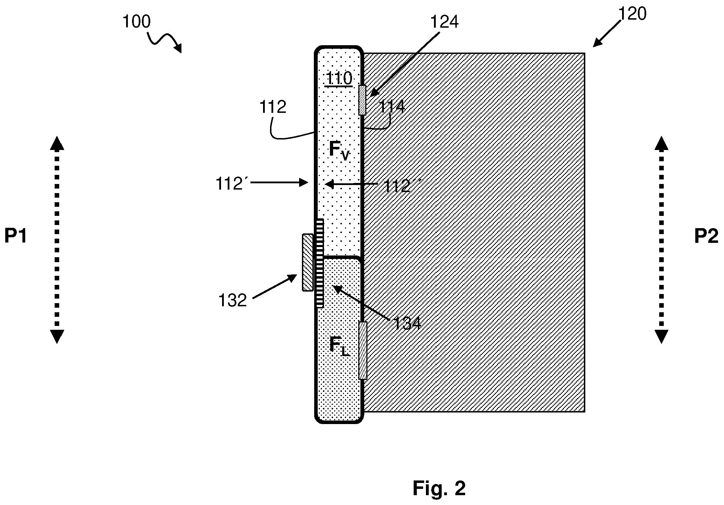

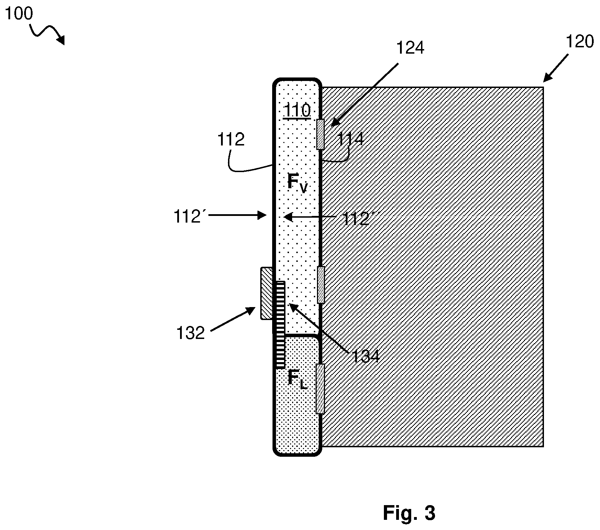

Fig. 1 - 3 shows a two-phase heat sink 100 shown in cross-sectional side view according to embodiments of the invention. With reference to Fig. 1, the two-phase heat sink 100 comprises a chamber 110 configured to receive a cooling fluid F. The chamber 110 thus comprises a first wall section 112 and a second wall section 114 arranged opposite to the first wall section 112. The first wall section 112 and the second wall section 114 may extend from a bottom section 116 to a top section 118 of the chamber 110. The two-phase heat sink 100 further comprises cooling fins 120 coupled to the chamber 110 thereby allowing the cooling fluid F to circulate between the chamber 110 and the cooling fins 120 in operation. The two-phase heat sink 100 further comprises an attachment area 132 arranged at an outer surface 112' of the first wall section 112 for attaching a heat source 200 (not shown in Fig. 2 and 3) to the first wall section 112. The two-phase heat sink 100 finally comprises a wick area 134 for converting the cooling fluid F from a liquid phase F_{V} to a vapor phase F_{L}. In embodiments of the invention, the wick area 134 is arranged at an inner surface 112" of the first wall section 112, and the attachment area 132 and the wick area 134 overlap with each other at least partly.

The attachment area 132 may comprises any suitable attachment means for attaching the heat source 200 to the first wall section 112. Non-limiting examples of attachment means are adhesive such as different types of thermal glues, welding bonding, thermal interface materials, etc. The heat source 200 may be any type of heat source that needs cooling for proper function such as processors, memory chips and other electronic devices.

The cooling fluid F may thus have liquid phase or vapor phase in the two-phase heat sink 100 depending on the temperature. By converting the cooling fluid F from liquid phase to vapor phase the heat dissipation increases compared to heat sinks not applying the two-phase principle. Non-limiting examples of cooling fluid that may be used are water, R1233ZD, R1336MZZ, HP-1, etc.

Further, as also shown in Fig. 1, the second wall section 114 is parallel to the first wall section 112 in embodiments of the invention. This may be understood such that the first wall section 112 extends in a first plane P1 and the second wall section 114 extends in a second plane P2 as shown in Fig. 1. In operation the first P1 and second P2 plane and thus the first wall section 112 and second plane P2 may be arranged substantially vertical and hence the bottom section 116 and the top section 118 substantially horizontal. Thus, the cooling fluid F can more quickly flow down in the two-phase heat sink 100. The chamber 110 is connected to the cooling fins 120 by one or more input/output ports 124. In Fig. 1 three input/output ports 124 are shown arranged at different vertical heights in the two-phase heat sink 100. The size of the different input/output ports 124 may also vary as shown in Fig. 1.

Thus, in the present disclosure a cooling solution is presented to significantly improve equivalent thermal conductivity along the heat transfer path from heat source to surrounding air without enlarging the overall size of the two-phase heat sink 100. The solid substrate in conventional solutions is replaced by an accommodating chamber 110 holding a cooling fluid F. The chamber 110 is connected to cooling fins 120 with micro-channels to ensure sufficient evaporation and condensation reflux of the cooling fluid F in the three-dimensional space. Higher equivalent thermal conductivity, e.g., above 2000 W/mK, can therefore be achieved through the liquid-vapor phase change of the cooling fluid F in the disclosed solution. Further, in order to increase the boiling enhancement and make the cooling fluid F more easy to boil, the inside surface area of the chamber 110 comprises a wick area 134 which may have a microstructure. The wick area 134 may e.g., be aluminum-based and hence directly formed at the inside surface area 112' of the chamber 110.

Depending on the cooling application, the relation between the size of the wick area 134 and the size of the attachment area 132 may vary according to embodiments of the invention. For example, in some cooling applications the wick area 134 and the attachment area 132 have substantially the same size as shown in Fig. 1. However, in other applications, the wick area 134 is larger than the attachment area 132 as shown in Fig. 2. The relationship between the two mentioned areas may e.g., depend on heat load of the heat source(s). For example, if the heat consumption is high and the temperature is high, a larger wick area is needed for heat dissipation.

Further parameters that may be considered when designing the herein disclosed two-phase heat sink 100 is the spatial relationship between the wick area 134 and the attachment area 132. As may be noted from Fig. 1, the wick area 134 and the attachment area 132 may be aligned in relation to each other in the first plane P1. However, the wick area 134 and the attachment area 132 may in other applications be offset in relation to each other as exemplified in Fig. 3. In this particular example, the wick area 134 is also offset in relation to the attachment area 132 in the gravity direction G of the two-phase heat sink 100 in operation. The gravity direction G is illustrated with a bold arrow.

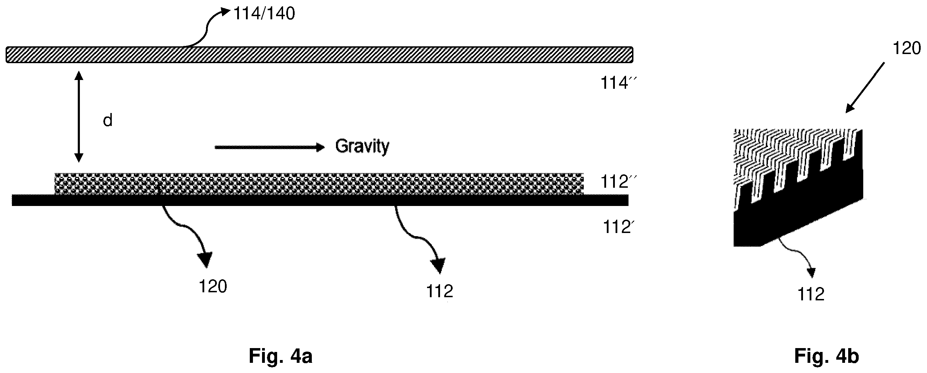

Fig. 4a and 4b show in detail examples of a wick structure used in the present two-phase heat sink 100. In embodiments of the invention, the wick area 134 may be a so-called porous wick microstructure for improved boiling capacity thereby further reducing the boiling surface excess temperature and make the boiling of the cooling fluid F more efficient. The porous wick microstructure may be realized in many different structural configurations. For example, the porous wick microstructure may be machined directly on the inside surface of the chamber 110 to replace a computer numerical control (CNC) machining smooth surface. The surface of the accommodating chamber 110 may be processed to form an aluminum-based wick porous microstructure. The porous wick microstructure can be formed through different processes such as micro-fin processing, powder sintering, laser machining, etc. Instead of directly machining the wick microstructure on the substrate surface, another option is to integrate a pre-processed wick microstructure module with the substrate through a soldering process. The welding of the wick microstructure module can be performed after that the cooling fins 120 have been brazed to avoid the effect of high brazing temperature on the wick microstructure.

Fig. 4a shows a cross-sectional side view of a porous wick microstructure 120 arranged at the inside surface of the first wall section 112 of the chamber 110. The porous wick microstructure 120 can increase the boiling nucleation core and make the cooling fluid F boil more easily compared to a smooth surface. The porous wick microstructure 120 can also adsorb the cooling fluid F to a higher vertical position in the two-phase heat sink 100 by capillary forces, which means that less cooling fluid F needs to be used for improved heat dissipation and lighter weight. The direction of gravity when the two-phase heat sink 100 is in operation is also shown in Fig. 4a with the bold arrow.

Fig, 4b shows a cross sectional perspective view of a detail of another wick microstructure. The shape of the wick microstructure in Fig. 4b differs from the one shown in Fig. 4a. The microstructure in Fig. 4b have a micro-fin geometry which is easier to produce compared to the porous microstructure structure shown in Fig. 4a. The height of the micro-fins in Fig. 4b may be below 1000 µm and have a pitch in the range of 400 - 500 µm but are not limited thereto.

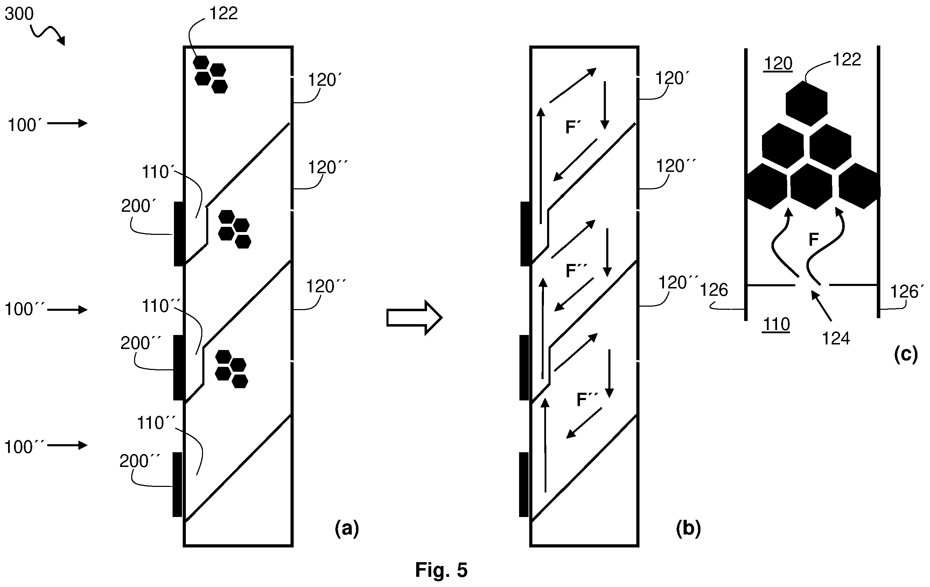

Fig. 5 - 8 shows and illustrates the design, layout and function of heat sinks 300 according to embodiments of the invention. In general, the heat sink 300 for cooling electrical heat sources 200 herein disclosed comprises a first two-phase heat sink 100' according to embodiments of the invention and at least one second two-phase heat sink 100" according to embodiments of the invention. Thus, the heat sink 300 may include two or more two-phase heat sinks 100 according to embodiments of the invention. The number of two-phase heat sinks may depend on the cooling application.

Fig. 5 shows in a cross-sectional side view a heat sink 300 comprising multiple two-phase heat sinks 100', 100". Fig. 5a shows how the different cooling fins 120', 120" are partitioned and arranged in relation to its respective chamber 110', 110" and heat source 200', 200" while Fig. 5b illustrates the circulation of the cooling fluid F', F" in the independent two-phase heat sinks 100', 100" of the common heat sink 300. In this particular example, the cooling fins 120 are so called roll-bonded cooling fins having a honeycomb structure which is also illustrated.

Different types of roll-bonded cooling fins exist in the art and in an example of the invention, the roll-bonded cooling fins comprise a first plate section 126 and a second plate section 126' as shown in Fig. 5c. Multiple supporting elements 122 are arranged between the first plate section 126 and the second plate section 126' so that micro-channels are formed in the space between the supporting elements 122, which may form a honeycomb structure as previously mentioned. The cooling fluid F can therefore circulate in the micro channels between the supporting elements 122 so that heat is dissipated from the cooling fins 120 and transferred to the surrounding air. The supporting elements 122 may in embodiments of the invention be integrated with the first plate section 126 and the second plate section 126', e.g., by brazing, hot pressing or any other suitable technique. Further, the distance between two adjacent supporting elements 122 may be in the range between 1.0 - 5.0 mm and preferably in the range between 3.0 - 4.0 mm according to embodiments of the invention. The chamber 110 may be coupled to the roll-bonded cooling fins 122 via one or more input/output ports 124 as also shown in Fig. 5c.

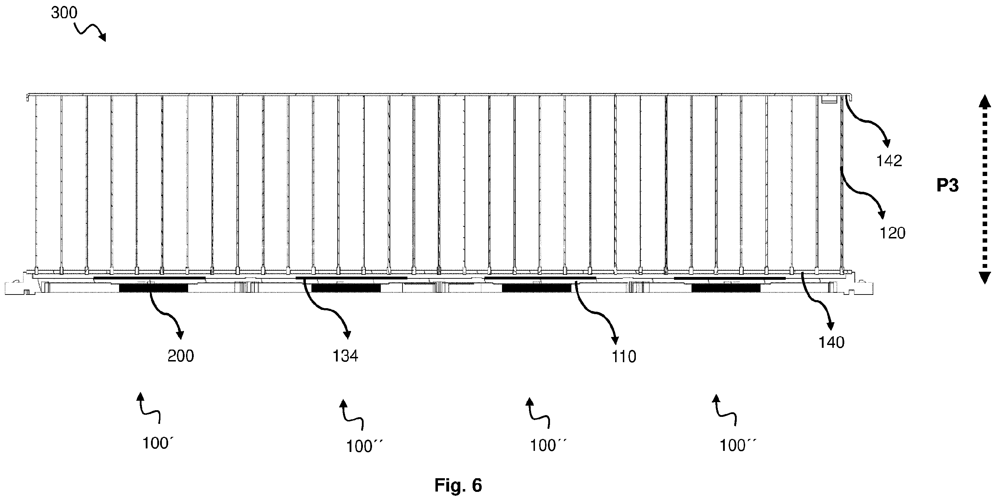

Fig. 6 shows a heat sink 300 in a cross-sectional side view. The heat sink 300 comprises in this example four independent two-phase heat sinks 100', 100" according to embodiments of the invention arranged in a stack formation. The independent two-phase heart sinks 100', 100" each comprises a heat source 200 with its attachment area and a corresponding wick area 134. The second wall section 114 of the chamber 110 may be formed from a cover plate 140, and the cooling fins 120 may thus extend through the cover plate 140 (in a plane P3 illustrated with dashed arrow) perpendicular to the first wall section 112 and thus also perpendicular to the direction of gravity G, see Fig. 1. The independent cooling fins 120 may structurally be connected to each other by a common louver plate 142 at a remote end distal in relation to the cover plate 140. The louver plate 142 mechanically holds the cooling fins 120 together for structural robustness.

In embodiments of the invention, a distance or a gap d between the wick area 134 and an inside surface 114" of the second wall section 114 is in the range between 1.0 - 10.0 mm, preferably in the range between 1.5 - 7 mm, and more preferably in the range between 1.5 - 5 mm. The distance d is illustrated in Fig. 4a. These provided distance ranges between the wick area 134 and the inside surface 114" of the second wall section 114 have been verified to provide optimal working fluid boiling space. In addition to enhancing the boiling of the cooling fluid F, the wick area 134 can also absorb the cooling fluid F to a higher vertical position in the heat sink by capillary forces, which means that less cooling fluid F needs to be used but still provide improved heat dissipation and a lighter heat sink.

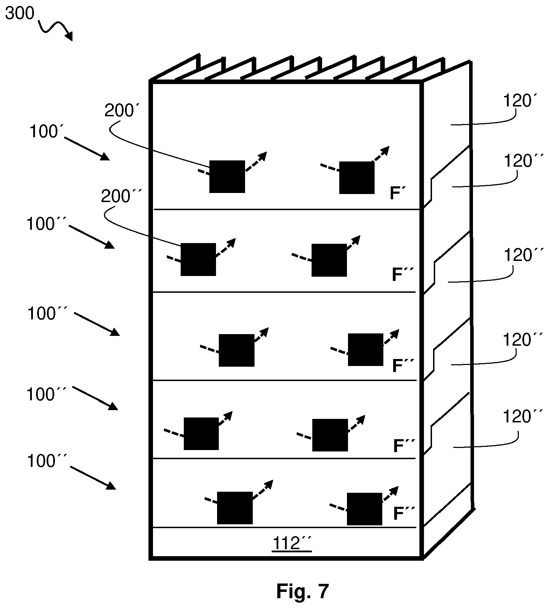

Fig. 7 shows a heat sink 300 in a perspective side view comprising five independent two-phase heat sinks 100', 100" arranged in a stack formation. The dashed curved arrows that passe through the heat sources 200' in Fig. 7 illustrate the internal flow of the cooling fluid F', F" in respective two-phase heat sink 100', 100" between the chamber 110 and the cooling fins 120. Thus, to maximize the boiling and evaporation phase transition of the cooling fluid F while the liquid in the chamber 110 should not be dried, the heat sink 300 is divided into multiple independent two-phase heat sinks 100 that may be arranged according to the heat source distribution of the heat sink 300. In particular, the temperature uniformity of the entire heat sink 300 can be greatly improved by having multiple two-phase heat sinks 100 according to the distribution of the heat sources 200'. 200". Thus, it is herein disclosed that the cooling fluid F' of the first two-phase heat sink 100' is separated from the cooling fluid F" of the second two-phase heat sink 100" and so on, which means that cooling fluid of the different chambers of the different two-phase heat sinks 100', 100" are separated without any interconnections therebetween.

However, the general design of the heat sink 300 implies that the first two-phase heat sink 100' and the at least one second two-phase heat sink 100" have a common substrate plate 144 and further be mechanically connected to each other as shown in Fig. 5 - 7. The mechanical connection implies that there will be thermal transfer between the two-phase heat sinks 100', 100".

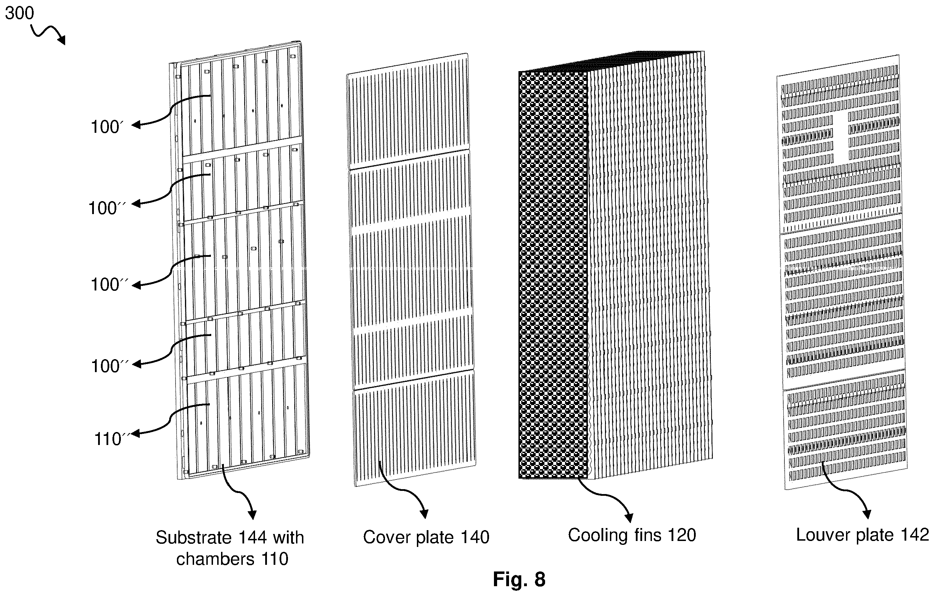

Fig. 8 shows a heat sink 300 in an exploded perspective side view according to embodiments of the invention. The disclosed heat sink 300 comprises a substrate plate 144 with accommodating chambers 110, a cover plate 140 for the accommodating chambers, cooling fins 120 with roll-bonded micro-channels and a louver plate 142. The substrate plate 144, the cover plate 140, and the cooling fins 110 may be integrated together through brazing, which means that each accommodating chamber -110', 110" is connected to its corresponding cooling fins 120', 120" thereby ensuring a larger three-dimensional space for evaporation and condensation of the cooling fluid F. The five independent chambers 110', 110" may be arranged in the heat sink 300 according to a heat source distribution, i.e., the placement of the heat sources (not shown in Fig. 8). The number, shape and volume of the independent chambers 110', 110" can be varied. Further, the partition design of the cooling fins corresponds to partition design of the chambers to ensure that the cooling fluid of each chamber can carry out the condensation cycle without interfering with each other. The partition design of the cooling fins can also be varied according to the heat consumption of the corresponding heat source(s). In general, an area with high heat generation can so to speak "borrow" the condensation space of an area with low heat generation by partitioning. Through this layout, the temperature uniformity and cooling capacity of the substrate and the cooling fins can be significantly improved.

Moreover, the upper and lower side openings of the cooling fins need to be brazed simultaneously with other components of the heat sink 100 to form a loop. However, only the openings close to the substrate 144 need to be brazed with the cover plate 140 according to embodiments of the invention. This means approximately 50% reduction in brazing area and a lower risk of leakage of cooling fluid F. Further, in the case of multiple different chamber partition design, only one type of cooling fin may be used, which means higher flexibility and easier manufacturing thus reducing production cost.

Finally, it should be understood that the invention is not limited to the embodiments described above, but also relates to and incorporates all embodiments within the scope of the appended independent claims.

## Claims

1. A two-phase heat sink (100) for cooling an electrical heat source (200), the two-phase heat sink (100) comprising:
a chamber (110) configured to receive a cooling fluid (F), the chamber (110) comprising a first wall section (112) and a second wall section (114) arranged opposite to the first wall section (112);
cooling fins (120) coupled to the chamber (110) thereby allowing the cooling fluid (F) to circulate between the chamber (110) and the cooling fins (120) in operation;
an attachment area (132) arranged at an outer surface (112') of the first wall section (112) for attaching a heat source (200) to the first wall section (112); and
a wick area (134) for converting the cooling fluid (F) from a liquid phase to a vapor phase, the wick area (134) being arranged at an inner surface (112") of the first wall section (112), wherein the attachment area (132) and the wick area (134) overlap with each other at least partly, the two-phase heat sink being **characterized in that**
a distance between the wick area (134) and an inside surface (114") of the second wall section (114) is in the range between 1.0 - 10.0 mm, preferably in the range between 1.5 - 7 mm, and more preferably in the range between 1.5 - 5 mm.

2. The two-phase heat sink (100) according to claim 1, wherein the wick area (134) is a porous wick area.

3. The two-phase heat sink (100) according to claim 1 or 2, wherein the wick area (134) is larger than the attachment area (132).

4. The two-phase heat sink (100) according to any one of claims 1 to 3, wherein the wick area (134) and the attachment area (132) are aligned in relation to each other.

5. The two-phase heat sink (100) according to any one of claims 1 to 3, wherein the wick area (134) and the attachment area (132) are offset in relation to each other.

6. The two-phase heat sink (100) according to claim 5, wherein the wick area (134) is offset in relation to the attachment area (132) in a gravity direction of the two-phase heat sink (100) in operation.

7. The two-phase heat sink (100) according to any one of the preceding claims, wherein the cooling fins (120) are roll-bonded cooling fins.

8. The two-phase heat sink (100) according to claim 7, wherein the roll-bonded cooling fins comprise a first plate section (126) and a second plate section (126') and multiple supporting elements (122) arranged between the first plate section (126) and the second plate section (126'), and wherein a distance between two adjacent supporting elements (122) is in the range between 1.0 - 5.0 mm and preferably in the range between 3.0 - 4.0 mm.

9. The two-phase heat sink (100) according to claim 8, wherein the supporting elements (122) are integrated with the first plate section (126) and the second plate section (126').

10. The two-phase heat sink (100) according to claim 8 or 9, wherein the chamber (110) is coupled to the roll-bonded cooling fins via one or more input/output ports (124).

11. The two-phase heat sink (100) according to any one of the preceding claims, wherein the second wall section (114) is formed from a cover plate (140), and wherein the cooling fins (120) extend through the cover plate (140) perpendicular to the first wall section (112).

12. The two-phase heat sink (100) according to any one of the preceding claims, wherein the second wall section (114) is parallel to the first wall section (112).

13. A heat sink (300) for cooling electrical heat sources (200), the heat sink (300) comprising a first two-phase heat sink (100') according to any one of the preceding claims and at least one second two-phase heat sink (100") according to any one of the preceding claims.

14. The heat sink (300) according to claim 13, wherein the cooling fluid (F') of the first two-phase heat sink (100') is separated from the cooling fluid (F") of the second two-phase heat sink (100").

## Patentansprüche

1. Zweiphasiger Kühlkörper (100) zum Kühlen einer elektrischen Wärmequelle (200), wobei der zweiphasige Kühlkörper (100) Folgendes umfasst:
eine Kammer (110), die dazu ausgelegt ist, ein Kühlfluid (F) aufzunehmen, wobei die Kammer (110) einen ersten Wandabschnitt (112) und einen zweiten Wandabschnitt (114), der gegenüber dem ersten Wandabschnitt (112) angeordnet ist, umfasst;
Kühlrippen (120), die mit der Kammer (110) gekoppelt sind, wodurch ermöglicht wird, dass das Kühlfluid (F) im Betrieb zwischen der Kammer (110) und den Kühlrippen (120) zirkuliert;
einen an einer Außenfläche (112') des ersten Wandabschnitts (112) angeordneten Befestigungsbereich (132) zum Befestigen einer Wärmequelle (200) an dem ersten Wandabschnitt (112); und
einen Dochtbereich (134) zum Umwandeln des Kühlfluids (F) von einer flüssigen Phase in eine gasförmige Phase, wobei der Dochtbereich (134) an einer Innenfläche (112") des ersten Wandabschnitts (112) angeordnet ist, wobei sich der Befestigungsbereich (132) und der Dochtbereich (134) zumindest teilweise überlappen, wobei der zweiphasige Kühlkörper **dadurch gekennzeichnet ist, dass**
ein Abstand zwischen dem Dochtbereich (134) und einer Innenfläche (114") des zweiten Wandabschnitts (114) im Bereich zwischen 1,0 und 10,0 mm, vorzugsweise im Bereich zwischen 1,5 und 7 mm und noch bevorzugter im Bereich zwischen 1,5 und 5 mm liegt.

2. Zweiphasiger Kühlkörper (100) nach Anspruch 1, wobei es sich bei dem Dochtbereich (134) um eine porösen Dochtbereich handelt.

3. Zweiphasiger Kühlkörper (100) nach Anspruch 1 oder 2, wobei der Dochtbereich (134) größer ist als der Befestigungsbereich (132).

4. Zweiphasiger Kühlkörper (100) nach einem der Ansprüche 1 bis 3, wobei der Dochtbereich (134) und der Befestigungsbereich (132) zueinander ausgerichtet sind.

5. Zweiphasiger Kühlkörper (100) nach einem der Ansprüche 1 bis 3, wobei der Dochtbereich (134) und der Befestigungsbereich (132) versetzt zueinander sind.

6. Zweiphasiger Kühlkörper (100) nach Anspruch 5, wobei der Dochtbereich (134) im Verhältnis zu dem Befestigungsbereich (132) in Richtung der Schwerkraft des zweiphasigen Kühlkörpers (100) im Betrieb versetzt ist.

7. Zweiphasiger Kühlkörper (100) nach einem der vorhergehenden Ansprüche, wobei es sich bei den Kühlrippen (120) um walzplattierte Kühlrippen handelt.

8. Zweiphasiger Kühlkörper (100) nach Anspruch 7, wobei die walzplattierten Kühlrippen einen ersten Plattenabschnitt (126) und einen zweiten Plattenabschnitt (126') sowie mehrere Stützelemente (122), die zwischen dem ersten Plattenabschnitt (126) und dem zweiten Plattenabschnitt (126') angeordnet sind, umfassen und wobei ein Abstand zwischen zwei benachbarten Stützelementen (122) im Bereich zwischen 1,0 und 5,0 mm und vorzugsweise im Bereich zwischen 3,0 und 4,0 mm liegt.

9. Zweiphasiger Kühlkörper (100) nach Anspruch 8, wobei die Stützelemente (122) in den ersten Plattenabschnitt (126) und den zweiten Plattenabschnitt (126') integriert sind.

10. Zweiphasiger Kühlkörper (100) nach Anspruch 8 oder 9, wobei die Kammer (110) über einen oder mehrere Eingangs-/Ausgangsanschlüsse (124) mit den walzplattierten Kühlrippen gekoppelt ist.

11. Zweiphasiger Kühlkörper (100) nach einem der vorhergehenden Ansprüche, wobei der zweite Wandabschnitt (114) aus einer Deckplatte (140) ausgebildet ist und wobei sich die Kühlrippen (120) senkrecht zu dem ersten Wandabschnitt (112) durch die Deckplatte (140) erstrecken.

12. Zweiphasiger Kühlkörper (100) nach einem der vorhergehenden Ansprüche, wobei der zweite Wandabschnitt (114) parallel zu dem ersten Wandabschnitt (112) verläuft.

13. Kühlkörper (300) zum Kühlen von elektrischen Wärmequellen (200), wobei der Kühlkörper (300) einen ersten zweiphasigen Kühlkörper (100') nach einem der vorhergehenden Ansprüche und mindestens einen zweiten zweiphasigen Kühlkörper (100") nach einem der vorhergehenden Ansprüche umfasst.

14. Kühlkörper (300) nach Anspruch 13, wobei das Kühlfluid (F') des ersten zweiphasigen Kühlkörpers (100') von dem Kühlfluid (F") des zweiten zweiphasigen Kühlkörpers (100") getrennt ist.

## Revendications

1. Dissipateur thermique à deux phases (100) pour le refroidissement d'une source de chaleur électrique (200), le dissipateur thermique à deux phases (100) comprenant :
une chambre (110) configurée pour recevoir un fluide de refroidissement (F), la chambre (110) comprenant une première section de paroi (112) et une seconde section de paroi (114) disposée en face de la première section de paroi (112) ;
des ailettes de refroidissement (120) couplées à la chambre (110) permettant ainsi au fluide de refroidissement (F) de circuler entre la chambre (110) et les ailettes de refroidissement (120) en fonctionnement ;
une zone de fixation (132) disposée sur une surface extérieure (112') de la première section de paroi (112) pour fixer une source de chaleur (200) à la première section de paroi (112) ; et
une zone de mèche (134) destinée à convertir le fluide de refroidissement (F) d'un état liquide à un état gazeux, la zone de mèche (134) étant disposée sur une surface intérieure (112") de la première section de paroi (112), dans lequel la zone de fixation (132) et la zone de mèche (134) se chevauchent au moins partiellement, le dissipateur thermique à deux phases étant **caractérisé en ce que**
une distance entre la zone de mèche (134) et une surface intérieure (114") de la seconde section de paroi (114) est comprise entre 1,0 et 10,0 mm, de préférence entre 1,5 et 7 mm, et plus préférablement entre 1,5 et 5 mm.

2. Dissipateur thermique à deux phases (100) selon la revendication 1, dans lequel la zone de mèche (134) est une zone de mèche poreuse.

3. Dissipateur thermique à deux phrases (100) selon la revendication 1 ou 2, dans lequel la zone de mèche (134) est supérieure à la zone de fixation (132).

4. Dissipateur thermique à deux phases (100) selon l'une quelconque des revendications 1 à 3, dans lequel la zone de mèche (134) et la zone de fixation (132) sont alignées l'une par rapport à l'autre.

5. Dissipateur thermique à deux phases (100) selon l'une quelconque des revendications 1 à 3, dans lequel la zone de mèche (134) et la zone de fixation (132) sont décalées l'une par rapport à l'autre.

6. Dissipateur thermique à deux phases (100) selon la revendication 5, dans lequel la zone de mèche (134) est décalée par rapport à la zone de fixation (132) dans une direction de gravité du dissipateur thermique à deux phases (100) en fonctionnement.

7. Dissipateur thermique à deux phases (100) selon l'une quelconque des revendications précédentes, dans lequel les ailettes de refroidissement (120) sont des ailettes de refroidissement collées par laminage.

8. Dissipateur thermique à deux phases (100) selon la revendication 7, dans lequel les ailettes de refroidissement collées par laminage comprennent une première section de plaque (126) et une seconde section de plaque (126') et plusieurs éléments de support (122) disposés entre la première section de plaque (126) et la seconde section de plaque (126'), et dans lequel une distance entre deux éléments de support adjacents (122) est comprise entre 1,0 et 5,0 mm et de préférence entre 3,0 et 4,0 mm.

9. Dissipateur thermique à deux phases (100) selon la revendication 8, dans lequel les éléments de support (122) sont intégrés à la première section de plaque (126) et à la seconde section de plaque (126').

10. Dissipateur thermique à deux phases (100) selon la revendication 8 ou 9, dans lequel la chambre (110) est couplée aux ailettes de refroidissement collées par laminage via un ou plusieurs ports d'entrée/sortie (124).

11. Dissipateur thermique à deux phases (100) selon l'une quelconque des revendications précédentes, dans lequel la seconde section de paroi (114) est formée à partir d'une plaque de couverture (140), et dans lequel les ailettes de refroidissement (120) s'étendent à travers la plaque de couverture (140) perpendiculairement à la première section de paroi (112).

12. Dissipateur thermique à deux phases (100) selon l'une quelconque des revendications précédentes, dans lequel la seconde section de paroi (114) est parallèle à la première section de paroi (112).

13. Dissipateur thermique (300) pour le refroidissement de sources de chaleur électriques (200), le dissipateur thermique (300) comprenant un premier dissipateur thermique à deux phases (100') selon l'une quelconque des revendications précédentes et au moins un second dissipateur thermique à deux phases (100") selon l'une quelconque des revendications précédentes.

14. Dissipateur thermique (300) selon la revendication 13, dans lequel le fluide de refroidissement (F') du premier dissipateur thermique à deux phases (100') est séparé du fluide de refroidissement (F") du second dissipateur thermique à deux phases (100").
